# EUROPÄISCHE PATENTANMELDUNG

(11) **EP 3 361 316 A1**
(43) Veröffentlichungstag der Anmeldung: **15.08.2018**
(21) Anmeldenummer: 17156138.4
(22) Anmeldetag: 14.02.2017
(51) Int. Cl.: G03F 7/20, H01L 21/687, F15B 11/12, H01L 21/67, C23C 16/458

(54) **PNEUMATISCHE STIFTHUBVORRICHTUNG UND PNEUMATISCHER HUBZYLINDER**

(71) Anmelder: VAT Holding AG, 9469 Haag (CH)
(72) Erfinder: DÜR, Michael, A-6914 Hohenweiler (AT); KIENREICH, Martin, A-6912 Hörbranz (AT)
(74) Vertreter: Kaminski Harmann

(57) **Zusammenfassung**

Stifthubvorrichtung (10) für die Bewegung und Positionierung eines zu bearbeitenden Substrats, mit einem pneumatischen Antriebszylinder mit einem ein erstes zylindrisches Innenvolumen (25) einschliessenden zylindrischen Gehäuse (21) und einer entlang einer Bewegungsachse beweglich angeordneten ersten Kolbenanordnung mit einem ersten Kolben (22) und einer ersten Kolbenstange (23). Der erste Kolben (22) begrenzt das erste Innenvolumen (25). Die erste Kolbenstange (23) ragt aus dem zylindrischen Gehäuse (21) und die erste Kolbenanordnung ist durch eine Druckbeaufschlagung des ersten Innenvolumens (25) in eine Bestückungsposition verstellbar. Die Vorrichtung hat mindestens einen parallel in Richtung der Längsachse (L) beweglichen Tragstift (11), wobei der Tragstift (11) mit der ersten Kolbenstange (23) verbunden ist und der Tragstift (11) durch eine Bewegung der ersten Kolbenanordnung bewegbar ist. Der Antriebszylinder weist eine zweite Kolbenanordnung mit einem zweiten Kolben (32) und einer zweiten Kolbenstange (33) auf, wobei der zweite Kolben (32) ein zweites Innenvolumen (35) begrenzt, die zweite Kolbenanordnung koaxial zur ersten Kolbenanordnung bewegbar angeordnet ist und eine Endfläche der zweiten Kolbenstange (33) in Richtung des ersten Kolbens (22) weist. Die erste und die zweite Kolbenanordnung sind derart angeordnet, dass der erste Kolben (22) und die zweite Kolbenstange (33) in der Bestückungsposition berührungslos vorliegen und der erste Kolben (22) und die zweite Kolbenstange (33) in einer Bearbeitungsposition in Berührung sind.

## Beschreibung

Die Erfindung betrifft ein pneumatisches Stifthubsystem mit einem pneumatischen Hubzylinder und mindestens einem mit dem Hubzylinder gekoppelten Tragstift zur Bewegung und Positionierung eines Substrats in einer Prozesskammer und einen pneumatischen Hubzylinder mit einem einstellbaren Anschlagpunkt.

Stifthubsysteme, auch Pin-Lifter genannt, sind typischerweise zur Aufnahme und definierten Positionierung eines in einer Prozesskammer zu bearbeitenden Substrats konzipiert und vorgesehen. Diese kommen insbesondere bei Vakuumkammersystemen im Bereich der IC-, Halbleiter-, Flat Panel- oder Substratfertigung, die in einer geschützten Atmosphäre möglichst ohne das Vorhandensein verunreinigender Partikel stattfinden muss, zum Einsatz.

Derartige Vakuumkammersysteme umfassen insbesondere mindestens eine zur Aufnahme von zu bearbeitenden oder herzustellenden Halbleiterelementen oder Substraten vorgesehene, evakuierbare Vakuumkammer, die mindestens eine Vakuumkammeröffnung besitzt, durch welche die Halbleiterelemente oder anderen Substrate in die und aus der Vakuumkammer führbar sind. Beispielsweise durchlaufen in einer Fertigungsanlage für Halbleiter-Wafer oder Flüssigkristall-Substrate die hochsensiblen Halbleiter-oder Flüssigkristall-Elemente sequentiell mehrere Prozess-Vakuumkammern, in denen die innerhalb der Prozess-Vakuumkammern befindlichen Teile mittels jeweils einer Bearbeitungsvorrichtung bearbeitet werden.

Solche Prozesskammern verfügen häufig über zumindest ein Transferventil, dessen Querschnitt dem Substrat und Roboter angepasst ist und durch welches das Substrat in die Vakuumkammer eingebracht und ggf. nach der vorgesehenen Bearbeitung entnommen werden kann. Alternativ kann z.B. ein zweites Transferventil vorgesehen sein, durch das das bearbeitete Substrat aus der Kammer gebracht wird.

Das Führen des Substrats, z.B. eines Wafers, erfolgt beispielsweise mit einem entsprechend ausgebildeten und gesteuerten Roboterarm, der durch die mit dem Transferventil bereitstellbare Öffnung der Prozesskammer durchführbar ist. Das Bestücken der Prozesskammer erfolgt dann mittels Greifen des Substrats mit dem Roboterarm, Bringen des Substrats in die Prozesskammer und definiertes Ablegen des Substrats in der Kammer. Das Leeren der Prozesskammer erfolgt in entsprechender Weise.

Für das Ablegen des Substrats und für die genaue Positionierung des Substrats in der Kammer muss eine verhältnismässig hohe Genauigkeit und Beweglichkeit des Substrats gewährleistet sein. Hierfür werden Stifthubsysteme eingesetzt, die eine Mehrzahl von Auflagepunkten für das Substrat und damit eine Lastverteilung (aufgrund des Eigengewichts des Substrats) über das gesamte Substrat bereitstellen.

Das Substrat wird mittels des Roboters auf den ausgefahrenen Tragstiften des Hubsystems abgelegt und durch ein Absenken der Stifte auf einem Träger, z.B. einer Potentialplatte, abgelegt. Hierzu wird der Roboterarm, der typischerweise das Substrat trägt, aus der Kammer gefahren. Die Stifte können nach dem Ablegen des Substrats weiter abgesenkt werden und liegen dann von diesem separiert vor, d.h. es besteht kein Kontakt zwischen den Stiften und dem Substrat. Nach Entfernen des Roboterarms und Schliessen (und Einbringen von Prozessgas bzw. Evakuieren) der Kammer wird der Bearbeitungsschritt durchgeführt.

Eine geringe Krafteinwirkung auf das Substrat ist insbesondere auch nach der Durchführung des Prozessschrittes in der Kammer und bei einem nachfolgenden Anheben des Substrats von hoher Bedeutung. Das Substrat weist typischerweise eine relativ glatte Oberfläche auf, die beim Ablegen mit dem Träger in Kontakt kommt und auf diesem aufliegt. Hierdurch kann beim Versuch das Substrat von dem Träger zu lösen durch einen zwischen dem Substrat und dem Träger wirkenden Unterdruck eine Art des Anhaftens resultieren - z.B. verursacht durch Lufteinschlüsse. Wird nun das Substrat zu schnell von dem Träger weggedrückt, kann es hierbei zu einem Bruch des Substrats kommen, da die Haftkräfte zumindest an gewissen Auflagepunkten nicht überwunden oder aufgelöst werden können. Zudem kann auch bei einem Zustandekommen des Kontakts zwischen den Tragstiften und dem Substrat ein dabei auftretendes Anstossen an dem Substrat zu einer unerwünschten Beanspruchung (oder Bruch) führen. Eine entsprechende Krafteinwirkung auf das Substrat ist also ein kritischer Faktor bei dem Substrathandling innerhalb der Kammer.

Gleichzeitig soll neben einer möglichst sanften und schonenden Behandlung der zu bearbeitenden Substrate eine ebenso möglichst kurze Bearbeitungszeit ermöglicht werden. Dies bedeutet, dass das Substrat möglichst schnell in die definierten Zustände - Be- und Entladeposition und Bearbeitungsposition - in der Kammer gebracht werden kann.

Zur Vermeidung von unerwünschten Stössen bei z.B. der Bearbeitung von Halbleiterwafern schlägt die US 6,481,723 B1 die Verwendung einer speziellen Stoppvorrichtung anstelle von harten Bewegungsanschlägen in einem Pin-Lifter vor. Allfällige Hartplastikanschläge sollen hier durch eine Kombination eines weicher ausgestalteten Anschlagteils und eines Hartanschlags ersetzt werden, wobei für die Bewegungsbegrenzung zunächst der Kontakt mit dem weichen Anschlagteil hergestellt wird und nachfolgend und entsprechend abgedämpft der harte Anschlag in Kontakt gebracht wird.

Die US 6,646,857 B2 schlägt eine Regelung der Hebebewegung mittels einer erfassten auftretenden Kraft vor. Die Tragstifte können hier in Abhängigkeit des erhaltenen Kraftsignals bewegt werden, so dass die Hebekraft an den Tragstiften stets entsprechende dosiert und kontrolliert auf den Wafer wirkt.

Die beiden genannten Ansätze werfen jedoch weitere Schwierigkeiten auf, die sich generell auf die Steuerung der Hebevorrichtung beziehen. Beispielsweise kann ein zweiteiliges Anschlagelement nicht allein ein gewünscht sanftes Anheben eines Wafers bereitstellen. Hierzu ist zudem eine entsprechend angepasste Steuerung des Antriebs erforderlich. Auch eine Regelung anstelle einer Steuerung schafft eine zusätzliche Komplexität durch Mehraufwand und vermag z.B. eventuelle Störungen im System (z.B. auftretende Reibkräfte) nicht zu erkennen, sondern versucht typischerweise eine solche Störung zu "überregeln". Durch die vorgeschlagenen Lösungen wird also zum einen ein deutlich komplexeres System geschaffen und zum zweiten eine mögliche Fehlererkennung ausgeschlossen.

Ein weiterer Aspekt für Arbeitsprozesse unter Vakuumbedingungen und bei angelegten Potentialen ist der mögliche Einfluss durch elektrische und/oder magnetische Störquellen. In diesem Kontext ist insbesondere auch bei der Ausgestaltung eines Stifthubsystems auf mögliche Einflüsse auf den Bearbeitungsprozess zu achten. So schlägt z.B. die US 2005/0092438 A1 eine Hebevorrichtung vor, deren Tragstifte mittels eines nicht-leitenden Materials von einer Steuerplatte elektrisch getrennt werden können.

Bei dieser Lösung bleibt jedoch nachteilig, dass ein Teil des mit dem elektrischen Antrieb verbundenen Hebesystems in der Prozesskammer vorliegt und dabei weiterhin eine entsprechende Störgrösse bilden kann.

Es ist daher Aufgabe der vorliegenden Erfindung ein verbessertes Stifthubsystem bereitzustellen, das zum einen ein kontrolliertes Anheben eines Substrats und zudem eine systembedingte potentielle Störung eines Bearbeitungsprozesses durch z.B. elektromagnetische Einflüsse vermeidet.

Zudem ist es Aufgabe der Erfindung ein derart verbessertes Stifthubsystem bereitzustellen, dass ein geplantes Anheben eines Werkstücks schnell und zerstörungsfrei erfolgen kann.

Der Erfindung liegt weiterhin die Aufgabe zugrunde, ein entsprechend verbessert ausgestaltetes Antriebskonzept für eine Stifthebevorrichtung bereitzustellen.

Diese Aufgaben werden durch die Verwirklichung der kennzeichnenden Merkmale der unabhängigen Ansprüche gelöst. Merkmale, die die Erfindung in alternativer oder vorteilhafter Weise weiterbilden, sind den abhängigen Patentansprüchen zu entnehmen.

Die vorliegende Erfindung betrifft ein Antriebskonzept für eine Stifthubvorrichtung bzw. unmittelbar eine damit ausgestattet Stifthubvorrichtung. Der Antrieb ist in Form eines pneumatischen (Hub-) Zylinders mit einer Rückstellvorrichtung vorgeschlagen. Mittels einer pneumatischen Auslegung werden im Vergleich zu elektrisch betriebenen Antrieben allfällige Störeinflüsse aufgrund von elektromagnetischen Feldern vermieden. Hierdurch wird also bereits ein verlässlicherer Bearbeitungsprozess in einer damit ausgerüsteten Vakuumkammer bereitgestellt.

Hinsichtlich des Problems des schonenden Anhebens eines in der Vakuumprozesskammer vorliegenden Werkstücks (Substrats), wie beispielsweise eines Halbleiterwafers, in Verbindung mit einer dennoch möglichst kurzen Bearbeitungszeit sieht die erfindungsgemässe Lösung den Hubzylinder mit einer doppelten Kolbenanordnung vor. Mit einer solchen Ausführung kann eine kritische Hubbewegung in zwei Phasen realisiert werden. In einer ersten Phase wird das Substrat mit moderater und ggf. zunehmender Krafteinwirkung verhältnismässig langsam von einer Auflage abgehoben.

Die Auflage kann z.B. eine ebene und glatte Platte sein, mit der ein ebenso glattes Substrat bei Kontakt zusammenhält, da zwischen den beiden Kontaktflächen eine Adhäsion (z.B. aufgrund von auftretenden kurzreichweitigen Kräften, z.B. Van-der-Waals Kräfte) eintreten kann und sich das Substrat daher nur mit einem gewissen Kraftaufwand wieder von der Auflage trennen lässt.

Die erste Abhebephase wird bis zu einem bestimmten Bewegungspunkt weitergeführt, insbesondere soweit bis das Substrat vollständig von der Auflage getrennt vorliegt.

Danach erfolgt ein Übergang in eine zweite, schnellere Bewegungsphase. Der Übergangspunkt ist durch die Auslegung bzw. Einstellung des Antriebs (Hubzylinders) definierbar.

In der ersten Phase wird die Bewegung massgeblich mit einem unteren Kolben des Hubzylinders bewirkt, in der zweiten Phase massgeblich mit einem oberen Kolben. Die Wirkungen der Kolbenkräfte können jedoch auch phasenüberlappend sein, d.h. eine durch den unteren Kolben verursachte Hubkraft muss nicht ausschliesslich die erste Bewegungsphase bewirken, sondern kann auch die zweite Bewegungsphase mit beeinflussen. Die Kolben sind insbesondere so angeordnet, dass beide entlang einer gemeinsamen Bewegungsachse (z.B. Mittelsenkrechte bezüglich der Grundfläche des Hubzylinders) im Inneren des Zylinders beweglich sind.

Die Kräfte auf die beiden Kolben werden durch jeweilige Druckbeaufschlagungen in entsprechend den Kolben zugeordneten Druckbereichen (Volumina) realisiert. Diese Volumina liegen zueinander abgedichtet vor, damit für jeden Kolben eine definierte Hubkraft oder Hubkraftverlauf eingestellt und ggf. variiert werden kann. Dies erfolgt z.B. mittels einer entsprechenden Ausgestaltung der Luftzuleitungen für die Volumina mit beispielsweise verstellbaren Blenden in Druckluftkanälen. Durch den so einstellbaren Zustrom von Druckluft kann der Hubkraftverlauf bestimmt werden.

Unterschiedliche Hubkräfte bei gleichem Druck können beispielsweise durch eine Ausgestaltung von unterschiedlichen Kolbenflächen realisiert werden.

Die Erfindung betrifft also eine Stifthubvorrichtung, insbesondere einen Pin-Lifter, für die Bewegung (Heben und Senken) und Positionierung (z.B. auf einer Ablage in einer Bearbeitungsposition) eines zu bearbeitenden Substrats, insbesondere eines Wafers, in einer Vakuumkammer.

Die Stifthubvorrichtung hat einen pneumatischen Antriebszylinder mit einem ein erstes zylindrisches Innenvolumen einschliessenden zylindrischen Gehäuse und einer entlang einer parallel oder koaxial zu einer Längsachse erstreckten Bewegungsachse beweglich angeordneten ersten Kolbenanordnung mit einem ersten Kolben und einer ersten Kolbenstange. Die Längsachse ist durch das erste zylindrische Innenvolumen definiert. Der erste Kolben begrenzt dabei ebenso das erste Innenvolumen. Die erste Kolbenstange ragt aus dem zylindrischen Gehäuse. Die erste Kolbenanordnung ist durch eine Druckbeaufschlagung des ersten Innenvolumens insbesondere auf einer rückgestellten Nullposition in eine ausgefahrene Bestückungsposition verstellbar.

Kolben und Kolbenstange können insbesondere als ein Teil, also einstückig, ausgebildet sein. Auch sind zweitteilige Ausführungen denkbar, wobei die Kolbenstange z.B. mit dem Kolben verschraubt ist.

Die Stifthubvorrichtung weist zudem mindestens einen zumindest im Wesentlichen parallel oder koaxial in Richtung der Längsachse beweglichen Tragstift auf, wobei der Tragstift mit einem ausserhalb des zylindrischen Gehäuses vorliegenden äusseren Ende der ersten Kolbenstange verbunden ist und der Tragstift durch eine Bewegung der ersten Kolbenanordnung entsprechend linear bewegbar ist.

Der Antriebszylinder weist weiter eine zweite Kolbenanordnung mit einem zweiten Kolben und einer Kontaktfläche auf, wobei der zweite Kolben ein zweites von dem zylindrischen Gehäuse eingeschlossenes Innenvolumen begrenzt, insbesondere wobei das erste und das zweite Innenvolumen durch den zweiten Kolben voneinander getrennt vorliegen. Die zweite Kolbenanordnung ist zumindest im Wesentlichen koaxial zur Beweglichkeit der ersten Kolbenanordnung bewegbar angeordnet. Die Kontaktfläche weist in Richtung des ersten Kolbens.

Die erste Kolbenanordnung und die zweite Kolbenanordnung sind derart angeordnet, dass die erste Kolbenanordnung und die Kontaktfläche in der Bestückungsposition berührungslos vorliegen und die erste Kolbenanordnung und die Kontaktfläche in einer eingefahrenen Bearbeitungsposition in gegenseitiger Berührung sind.

Die eingefahrene Bearbeitungsposition ist insbesondere die Position des zweiten Kolbens in seiner weitest abgesenkten Stellung. In dieser Stellung weist das zweite Innenvolumen eine im Rahmen der Bewegung des zweiten Kolbens kleinste mögliche Ausdehnung auf.

In einer Ausführungsform weist die zweite Kolbenanordnung eine zweite Kolbenstange auf und eine Endfläche der zweiten Kolbenstange weist in Richtung der ersten Kolbenanordnung. Die Endfläche bildet hierbei die Kontaktfläche der zweiten Kolbenanordnung. Der erste Kolben und die zweite Kolbenstange liegen in der Bestückungsposition berührungslos vor und berühren sich in der eingefahrenen Bearbeitungsposition vermittels der Kontaktfläche.

In einer weiteren Ausführungsform kann die erste Kolbenstange derart ausgeformt sein, dass ein freies inneres Ende (im Inneren des Gehäuses vorliegend) der ersten Kolbenstange, das dem äusseren Ende der ersten Kolbenstange gegenüberliegt, in Richtung der Kontaktfläche weist, wobei die erste Kolbenstange und die Kontaktfläche in der Bestückungsposition berührungslos vorliegen und die erste Kolbenstange und die Kontaktfläche in einer eingefahrenen Bearbeitungsposition in Berührung sind. Insbesondere kann die erste Kolbenstange sich durch den ersten Kolben erstreckend ausgebildet und in fixer Position, insbesondere mittels Verschraubung, relativ zum ersten Kolben angeordnet sein.

Die Kontaktfläche der zweiten Kolbenanordnung kann insbesondere ein Teil einer in Richtung des ersten Kolbens weisenden Oberfläche des zweiten Kolbens sein. Der zweite Kolben ist in dieser Ausführung als scheibenartiger zylindrisches Element ausgebildet.

In einer Ausführungsform weist der Antriebszylinder einen unteren (zweiten) Druckluftkanal auf, der derart angeordnet ist, dass die zweite, untere und insbesondere die erste, obere Kolbenanordnung durch eine Druckbeaufschlagung des zweiten Innenvolumens durch den zweiten Druckluftkanal aus der eingefahrenen Bearbeitungsposition in eine Übergangsposition verstellbar ist. Der untere Druckluftkanal ist also mit dem zweiten Innenvolumen verbunden und ermöglicht eine Einleitung von Druckluft in dieses Volumen.

Zudem weist der Antriebszylinder einen oberen (ersten) Druckluftkanal auf, der derart angeordnet ist, dass die erste Kolbenanordnung durch eine Druckbeaufschlagung des ersten Innenvolumens durch den ersten Druckluftkanal aus der Übergangsposition in die ausgefahrene Bestückungsposition verstellbar ist. Der obere Druckluftkanal ist also mit dem ersten Innenvolumen verbunden und ermöglicht eine Einleitung von Druckluft in dieses erste Volumen.

In einer Ausführungsform kann der obere Druckluftkanal weiter so ausgeformt und angeordnet sein, dass mittels einer Drucklufteinleitung durch diesen Kanal der erste Kolben aus einer Nullstellung (d.h. der Kolben befindet sich an einem Anschlag in einer abgesenkten, eingefahrenen Position in dem Gehäuse) in die Bestückungsposition gehoben bzw. gedrückt werden kann.

Insbesondere weist die Stifthubvorrichtung eine Steuerungseinheit zur Ansteuerung jeweiliger Druckluftregelelement für den ersten und den zweiten Druckluftkanal auf, wobei die Steuerungseinheit eine spezifisch konfigurierte Hebefunktion zur Bewegung der ersten Kolbenanordnung in eine ausgefahrene Bestückungsposition aufweist. Bei Ausführung der Hebefunktion wird das Druckluftregelelement für den zweiten Druckluftkanal so angesteuert, dass das Druckluftregelelement für den zweiten Druckluftkanal die Druckbeaufschlagung des zweiten Innenvolumens bereitstellt und nachfolgend wird das Druckluftregelelement für den ersten Druckluftkanal so gesteuert, dass dieses die Druckbeaufschlagung des ersten Innenvolumens mit einem bestimmten zeitlichen Versatz relativ zur Druckbeaufschlagung des zweiten Innenvolumens bereitstellt. Der zeitliche Versatz hängt von einem Erreichen der Übergangsposition mit dem zweiten Kolben ab oder ist zeitlich gesteuert durch die Hebefunktion vorgegeben. D.h. die Druckbeaufschlagung des ersten Innenvolumens kann z.B. mit einer Mechanik so eingeleitet werden, dass die Mechanik die Druckbeaufschlagung erst bei dem Erreichen der Übergangsposition freigibt. Die zeitliche Steuerung kann z.B. elektronisch erfolgen, wobei ein Druckventil entsprechend geschaltet oder geregelt werden kann.

Gemäss einer Ausführungsform der Erfindung definiert der Antriebszylinder zumindest einen Anschlagpunkt für eine Bewegung der ersten oder der zweiten Kolbenanordnung, insbesondere des ersten oder zweiten Kolbens, wobei der zumindest eine Anschlagpunkt die ausgefahrene Bestückungsposition, die eingefahrenen Bearbeitungsposition oder die Übergangsposition definiert. Der Anschlagpunkt repräsentiert also eine Bewegungsbegrenzung für zumindest einen der Kolben in Längsrichtung.

Insbesondere ist die Position des zumindest einen Anschlagpunkts in einem definierten Anschlagbereich mit Bezug zur Längsachse variierbar, insbesondere wobei eine Erstreckung des Anschlagbereichs mindestens 0.5 mm oder 1 mm in Richtung der Längsachse beträgt. In anderen Worten kann der Anschlagpunkt innerhalb eines bestimmten Bereichs verstellt werden.

Durch eine solche Einstellbarkeit kann z.B. eine abgesenkte Stellung des mindestens einen Tragstifts eingestellt, definiert und verändert werden. Entsprechend kann der Übergangspunkt von der ersten Hubphase zur zweiten Hubphase, d.h. in welchem Umfang ein moderates Anheben des Substrats erfolgen soll und ab welchem Punkt eine schnellere Hubbewegung eingeleitet werden kann.

In einer Ausführung der Vorrichtung weist das Gehäuse mindestens zwei - insbesondere radial gegenüberliegende - Ausnehmungen auf, wobei die Ausnehmungen die Gehäusewand durchdringen. Eine Erstreckung der Ausnehmungen in eine Richtung parallel zur Längsachse definiert den Anschlagbereich.

Insbesondere weist der Antriebszylinder zumindest ein in den Ausnehmungen positioniertes Anschlagelement, insbesondere einen Querbalken, mit einer definierten Höhe in Richtung der Längsachse auf, wobei die Höhe kleiner ist als die Erstreckung der Ausnehmungen, und weist zudem zumindest einen mit dem Anschlagelement zusammenwirkenden Verstellmechanismus auf. Das Anschlagelement liegt vorzugsweise so in dem ersten oder zweiten Innenvolumen vor, dass dadurch eine Barriere für die Bewegungstrecke des ersten und/oder des zweiten Kolbens bereitgestellt ist. Der jeweilige Kolben stösst dann insbesondere an dem Anschlagelement an.

In einer Ausführungsform ist das Anschlagelement mit einer zentralen Ausnehmung so ausgebildet und angeordnet, dass die ersten oder die zweite Kolbenstange durch diese zentrale Ausnehmung ragt und damit ein Begrenzungspunkt für die Bewegung der Endfläche der Kolbenstange entfernt von dem Anschlagpunkt, insbesondere um die Länge der Kolbenstange versetzt, bereitgestellt ist.

Das Anschlagelement kann alternativ z.B. sternförmig, hexagonal oder als Lochplatte ausgeführt sein, wobei ein Um- oder Durchströmen des Anschlagelements mit einer bestimmten Luftmenge pro Zeiteinheit, insbesondere bei bekanntem Differenzdruck, gewährleistet ist. Die Ausnehmungen in der Gehäusewand können entsprechend korrespondierend vorgesehen sein. Das Anschlagelement kann generell drehgesichert gelagert sein.

Des Weiteren kann der Verstellmechanismus als Ring mit einem Innengewinde ausgebildet und an der Gehäuseaussenseite, bzw. das Gehäuse umlaufend, angeordnet sein. Das Anschlagelement kann in diesem Kontext im Bereich der Ausnehmungen ein Segment eines mit dem Innengewinde korrespondierenden Aussengewindes aufweisen. Das Anschlagelement ist dann derart ausgeformt, insbesondere hinsichtlich dessen Dimensionierung bezüglich eines Innen- und/oder Aussendurchmessers des Innenvolumens bzw. des Gehäuses, dass das Innengewinde mit dem Aussengewinde zusammenwirkt. Hierdurch läuft also das Aussengewinde des Anschlagelements in dem Innengewinde des Rings, wobei das Anschlagelement vorzugsweise so (in den Ausnehmungen) gelagert ist, dass dieses nicht um die Längsachse verdrehbar ist. Die Position des Anschlagelements kann in dieser Konfiguration innerhalb des definierten Anschlagbereichs entlang einer parallel zur Längsachse erstreckten Verstellachse mittels Drehen des Rings variiert und eingestellt werden. Hierbei ist entsprechend der zumindest eine Anschlagpunkt verstellbar.

Eine definierte Steigung der Gewinde legt die Hubstrecke für das Anschlagelement entlang der Verstellachse pro Umdrehung des Rings fest.

In einer Ausführung kann der Antriebszylinder zumindest eine Rückstellfunktionalität aufweisen, mittels derer eine Rückstellkraft bereitstellbar ist, welche so auf die erste und/oder die zweite Kolbenanordnung wirkt, dass diese in die eingefahrene Bearbeitungsposition gedrückt wird. Mit dieser Rückstellfunktionalität kann ein Absenken der Kolben in den Zylinder bewirkt werden, insbesondere bei einer Reduzierung des Innendrucks in den Innenvolumina oder bei einer Entlüftung der Innenvolumina.

Diese Rückstellfunktionalität kann als Rückstellelement ausgebildet sein, insbesondere als Rückstellfeder, das derart angeordnet ist, dass die Rückstellkraft unmittelbar auf den ersten Kolben wirkt und bei einem Kontakt zwischen erstem Kolben und Kontaktfläche bzw. zweiter Kolbenstange mittelbar auf die zweite Kolbenanordnung wirkt.

Alternativ oder zusätzlich kann die Rückstellfunktionalität als steuerbarer, insbesondere pneumatischer, Rückstellmechanismus ausgebildet sein, wobei die Rückstellkraft auf den ersten Kolben durch Druckbeaufschlagung, insbesondere hinsichtlich deren Betrag und Verlauf, einstellbar ist. Hier wird durch ein Erzeugen und Vergrössern eines Drucks in einem Volumen, das bei dem Hub des ersten Kolbens verkleinert wird, eine Gegenkraft gegen die Hubkraft induziert.

Die Erfindung betrifft ausserdem einen pneumatischen Antriebszylinder, insbesondere Hubzylinder, insbesondere für eine Stifthubvorrichtung oder einen Pin-Lifter oder allgemeine Antriebsvorrichtung, mit einem ein erstes zylindrisches Innenvolumen einschliessenden zylindrischen Gehäuse und einer entlang einer parallel oder koaxial zu einer Längsachse erstreckten Bewegungsachse beweglich angeordneten ersten Kolbenanordnung mit einem ersten Kolben und einer ersten Kolbenstange. Die Längsachse ist durch das erste zylindrische Innenvolumen definiert. Der erste Kolben begrenzt das erste Innenvolumen und die erste Kolbenstange ragt aus dem zylindrischen Gehäuse. Die erste Kolbenanordnung ist durch eine Druckbeaufschlagung des ersten Innenvolumens in eine ausgefahrene Bestückungsposition verstellbar.

Der Zylinder weist ausserdem ein an einem ausserhalb des zylindrischen Gehäuses vorliegenden äusseren Ende der ersten Kolbenstange vorgesehenes Koppelelement zur Verbindung der ersten Kolbenstange mit einer mittels des Antriebszylinders zu bewegenden Komponente, insbesondere Tragstift einer Stifthubvorrichtung, und eine zweite Kolbenanordnung mit einem zweiten Kolben und einer Kontaktfläche auf. Der zweite Kolben begrenzt ein zweites von dem zylindrischen Gehäuse eingeschlossenes Innenvolumen, insbesondere wobei das erste und das zweite Innenvolumen durch den zweiten Kolben voneinander getrennt sind. Die zweite Kolbenanordnung ist zumindest im Wesentlichen koaxial zur ersten Kolbenanordnung bewegbar angeordnet, insbesondere ist die zweite Kolbenanordnung entlang der Bewegungsachse bewegbar. Die Kontaktfläche der zweiten Kolbenanordnung weist in Richtung des ersten Kolbens und die zweite und insbesondere die erste Kolbenanordnung ist durch eine Druckbeaufschlagung des zweiten Innenvolumens aus einer eingefahrenen Bearbeitungsposition in eine Übergangsposition verstellbar.

Die erste Kolbenanordnung und die zweite Kolbenanordnung sind derart angeordnet, dass die erste Kolbenanordnung und die Kontaktfläche in der ausgefahrenen Bestückungsposition berührungslos vorliegen und die erste Kolbenanordnung und die Kontaktfläche in einer eingefahrenen Bearbeitungsposition in Berührung sind.

Erfindungsgemäss weist der Antriebszylinder zumindest einen Anschlagpunkt für eine Begrenzung einer Bewegungsstrecke der ersten und/oder der zweiten Kolbenanordnung, insbesondere des ersten oder zweiten Kolbens, auf, wobei der zumindest eine Anschlagpunkt die ausgefahrene Bestückungsposition, die eingefahrenen Bearbeitungsposition und/oder die Übergangsposition definiert. Die Position des zumindest einen Anschlagpunkts ist innerhalb eines definierten Anschlagbereichs mit Bezug zur Längsachse variierbar, insbesondere wobei eine Erstreckung des Anschlagbereichs mindestens 0.5 mm oder 1 mm entlang einer parallel zur Längsachse erstreckten Verstellachse beträgt

In einer Ausführungsform des Zylinders weist die zweite Kolbenanordnung eine zweite Kolbenstange auf und eine Endfläche der zweiten Kolbenstange weist in Richtung der ersten Kolbenanordnung. Die Endfläche bildet hierbei die Kontaktfläche der zweiten Kolbenanordnung. Der erste Kolben und die zweite Kolbenstange liegen in der Bestückungsposition berührungslos vor und berühren sich in der eingefahrenen Bearbeitungsposition vermittels der Kontaktfläche.

In einer weiteren Ausführungsform kann die erste Kolbenstange derart ausgeformt sein, dass ein freies inneres Ende (im Inneren des Gehäuses vorliegend) der ersten Kolbenstange, das dem äusseren Ende der ersten Kolbenstange gegenüberliegt, in Richtung der Kontaktfläche weist, wobei die erste Kolbenstange und die Kontaktfläche in der Bestückungsposition berührungslos vorliegen und die erste Kolbenstange und die Kontaktfläche in einer eingefahrenen Bearbeitungsposition in Berührung sind. Insbesondere kann die erste Kolbenstange sich durch den ersten Kolben erstreckend ausgebildet und in fixer Position, insbesondere mittels Verschraubung, relativ zum ersten Kolben angeordnet sein.

Die Kontaktfläche der zweiten Kolbenanordnung kann insbesondere ein Teil einer in Richtung des ersten Kolbens weisenden Oberfläche des zweiten Kolbens sein. Der zweite Kolben ist in dieser Ausführung als scheibenartiger zylindrisches Element ausgebildet.

In einer Ausführung des Zylinders kann das Gehäuse zumindest zwei insbesondere radial gegenüberliegende Ausnehmungen aufweisen, wobei die Ausnehmungen die Gehäusewand durchdringen, und wobei eine Erstreckung der Ausnehmungen entlang der Verstellachse den Anschlagbereich definiert.

Insbesondere weist der Antriebszylinder zumindest ein in den Ausnehmungen angeordnetes Anschlagelement, insbesondere einen Querbalken, mit einer definierten Höhe in Richtung der Verstellachse auf, wobei die Höhe kleiner ist als die Erstreckung der Ausnehmungen. Der Antriebszylinder kann dann zudem zumindest einen mit dem Anschlagelement zusammenwirkenden Verstellmechanismus aufweisen.

Gemäss einer Ausführungsform kann der Verstellmechanismus als Ring mit einem Innengewinde ausgebildet und an der Gehäuseaussenseite angeordnet sein. Das Anschlagelement kann im Bereich der Ausnehmungen ein Segment eines mit dem Innengewinde korrespondierenden Aussengewindes aufweisen und das Anschlagelement kann ferner derart ausgeformt sein, insbesondere hinsichtlich dessen Dimensionierung bezüglich eines Innen- und/oder Aussendurchmessers des Innenvolumens bzw. des Gehäuses, dass das Innengewinde mit dem Aussengewinde zusammenwirkt. Die Position des Anschlagelements kann hierdurch innerhalb des definierten Anschlagbereichs entlang der Verstellachse mittels Drehen des Rings variiert und eingestellt werden, wobei der zumindest eine Anschlagpunkt verstellbar ist.

In einer weiteren Ausführungsform weist der Antriebszylinder zumindest eine Rückstellfunktionalität auf, mittels derer eine Rückstellkraft bereitstellbar ist, welche so auf die erste und/oder die zweite Kolbenanordnung wirkt, dass diese in die eingefahrene Bearbeitungsposition gedrückt wird.

Diese Rückstellfunktionalität kann als Rückstellelement ausgebildet sein, insbesondere als Rückstellfeder, das derart angeordnet ist, dass die Rückstellkraft unmittelbar auf den ersten Kolben wirkt und bei einem Kontakt zwischen erstem Kolben und Kontaktfläche bzw. zweiter Kolbenstange mittelbar auf die zweite Kolbenanordnung wirkt.

Alternativ oder zusätzlich kann die Rückstellfunktionalität des Antriebszylinders als steuerbarer, insbesondere pneumatischer, Rückstellmechanismus ausgebildet sein, wobei die Rückstellkraft auf den ersten Kolben durch Druckbeaufschlagung, insbesondere hinsichtlich deren Betrag und Verlauf, einstellbar ist. Hier wird durch ein Erzeugen und Vergrössern eines Drucks in einem Volumen, das bei dem Hub des ersten Kolbens verkleinert wird, eine Gegenkraft gegen die Hubkraft induziert.

In einer Ausführungsform des Antriebszylinders weist dieser Zylinder einen unteren (zweiten) Druckluftkanal auf, der derart angeordnet ist, dass die zweite, untere und insbesondere die erste, obere Kolbenanordnung durch eine Druckbeaufschlagung des zweiten Innenvolumens durch den zweiten Druckluftkanal aus der eingefahrenen Bearbeitungsposition in eine Übergangsposition verstellbar ist. Der untere Druckluftkanal ist also mit dem zweiten Innenvolumen verbunden und ermöglicht eine Einleitung von Druckluft in dieses Volumen.

Zudem weist der Antriebszylinder einen oberen (ersten) Druckluftkanal auf, der derart angeordnet ist, dass die erste Kolbenanordnung durch eine Druckbeaufschlagung des ersten Innenvolumens durch den ersten Druckluftkanal aus der Übergangsposition in die ausgefahrene Bestückungsposition verstellbar ist. Der obere Druckluftkanal ist also mit dem ersten Innenvolumen verbunden und ermöglicht eine Einleitung von Druckluft in dieses erste Volumen.

In einer Ausführungsform kann der obere Druckluftkanal weiter so ausgeformt und angeordnet sein, dass mittels einer Drucklufteinleitung durch diesen Kanal der erste Kolben aus einer Nullstellung (d.h. der Kolben befindet sich an einem Anschlag in einer abgesenkten, eingefahrenen Position in dem Gehäuse) in die Bestückungsposition gehoben bzw. gedrückt werden kann.

Die erfindungsgemässen Vorrichtungen werden nachfolgend anhand von in den Zeichnungen schematisch dargestellten konkreten Ausführungsbeispielen rein beispielhaft näher beschrieben, wobei auch auf weitere Vorteile der Erfindung eingegangen wird. Im Einzelnen zeigen:
- Fig. 1: eine schematische Darstellung einer Ausführungsform einer Vakuumbearbeitungsvorrichtung für einen Wafer mit einer erfindungsgemässen Hubvorrichtung;
- Fig. 2a-c: eine Ausführungsform für eine Stifthubvorrichtung gemäss der Erfindung in einer Querschnittsansicht;
- Fig. 3a-c: eine Ausführungsform eines Antriebs- bzw. Hubzylinders gemäss der Erfindung in einer Querschnittsansicht;
- Fig. 4: eine weitere Ausführungsform eines Antriebs-bzw. Hubzylinders gemäss der Erfindung in einer perspektivischen Darstellung; und
- Fig. 5: eine weitere Ausführungsform eines Antriebs-bzw. Hubzylinders gemäss der Erfindung im Querschnitt.

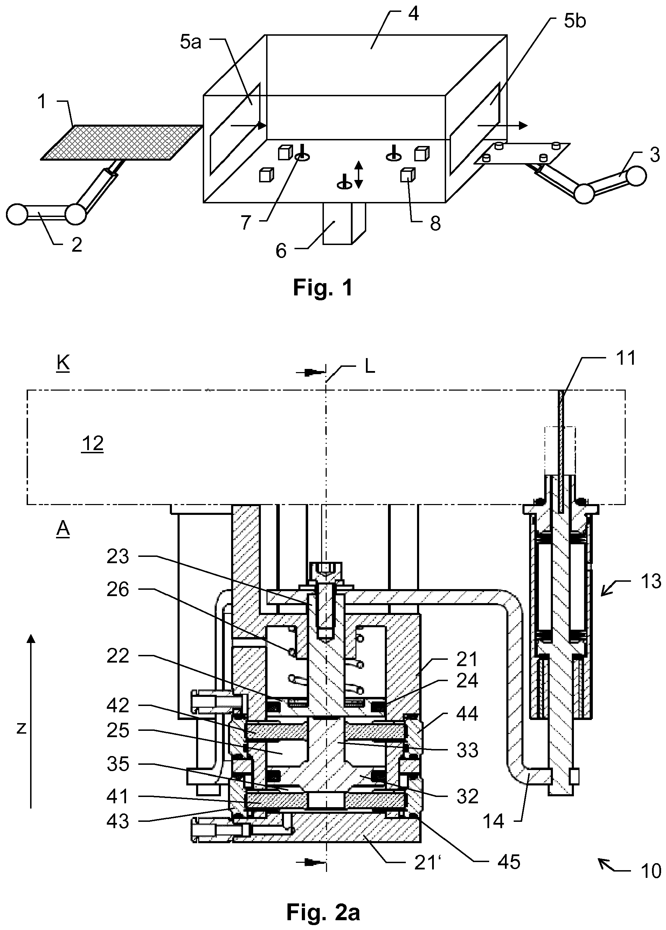

Figur 1 zeigt schematisch einen Prozessaufbau für eine Bearbeitung eines Halbleiterwafers 1 unter Vakuumbedingungen. Der Wafer 1 wird mittels eines ersten Roboterarms 2 durch ein erstes Vakuumtransferventil 5a in eine Vakuumkammer 4 eingebracht. Dort ermöglicht der Roboterarm 2 ein Ablegen des Wafers 1 auf ausgefahrenen Tragestiften 7 (hier: drei Stifte gezeigt) einer Stifthubvorrichtung. Der Wafer 1 liegt - wie gezeigt - typischerweise auf dem Roboterarm oder einer an dem Roboterarm 2,3 vorgesehenen Tragvorrichtung auf. Nach einem Auflegen des Wafers 1 auf den Stiften 7 werden der Roboterarm aus der Kammer 4 geführt, das Transferventil 5a verschlossen und die Stifte 7 abgesenkt. Dies erfolgt mittels eines Antriebs- oder Hubzylinders 6 der mit den drei Stiften 7 gekoppelt ist und somit eine gemeinsame Bewegung der Stifte 7 bereitstellt. Der Wafer 1 wird hierdurch auf den gezeigten vier Trageelementen 8 abgelegt. Der Antriebs- oder Hubzylinders 6 bildet zusammen mit den gekoppelten Stiften die erfindungsgemässe Stifthubvorrichtung. Aufbau und Funktion dieser Komponenten sind mit den folgenden Figuren detailliert beschrieben.

In diesem Zustand erfolgt eine geplante Bearbeitung (z.B. Beschichtung) des Wafers 7 unter Vakuumbedingungen und insbesondere in definierter Atmosphäre (d.h. mit einem bestimmten Prozessgas). Die Kammer 4 ist hierfür mit einer Vakuumpumpe und vorzugsweise mit einem Vakuumregelventil zur Regelung des Kammerdrucks gekoppelt (nicht gezeigt).

Nach der Bearbeitung erfolgt ein Anheben des Wafers 1 in eine Entnahmestellung wiederum mittels der Stifthubvorrichtung. Mit dem zweiten Roboterarm 3 wird in der Folge der Wafer 1 durch das zweite Transferventil 5b entnommen. Alternativ kann der Prozess mit nur einem Roboterarm konzipiert sein, wobei Bestückung und Entnahme dann durch ein einzelnes Transferventil erfolgen können.

Die Figuren 2a-c zeigen eine Ausführungsform für eine Stifthubvorrichtung 10 gemäss der Erfindung in einem Querschnitt. Die Vorrichtung 10 ist in drei unterschiedlichen Zuständen gezeigt.

Figur 2a zeigt die Vorrichtung 10 in einer eingefahrenen Bearbeitungsposition, in der typischerweise eine Bearbeitung des mit der Vorrichtung geführten und abgelegten Substrats erfolgt. In der Bearbeitungsposition sind die Tragestifte 11 der Vorrichtung 10, von denen hier aus Gründen der Übersichtlichkeit nur ein einzelner gezeigt ist, weitest möglich abgesenkt. Die Beschreibung mit Bezug zu dem einen gezeigten Stift 11 kann entsprechend auf weiter vorgesehene Stifte übertragen werden. Insbesondre weist die Stifthubvorrichtung 10 drei Tragestifte 11 in einer sternförmigen Anordnung auf. In der gezeigten Ausführung ist ein Kontaktbereich des Stiftes 11, mit welchem das Substrat im Rahmen des Anhebens oder Absenkens in Kontakt steht, auf ein gemeinsames Niveau mit einer Oberfläche einer Kammerwand 12 oder einer Auflage 12 für das Substrat gebracht.

Die Stifte 11 sind durch jeweilige Kopplungskomponenten 13 atmosphärisch von einem äusseren Kammerbereich A getrennt. Die Stifte 11 liegen also in der Kammeratmosphäre K vor. Die Kopplungskomponente 13 weist hierzu einen Balg auf, der eine Bewegung des Stiftes 11 in z-Richtung bei gleichzeitiger Vakuumabschirmung bereitstellt. Alternativ zu einer Balg-Lösung kann die Kopplungskomponente auch eine Schiebedurchführung oder andere Vakuumdichte Durchführung aufweisen (nicht gezeigt).

Der Tragstift 11 ist mittels eines Verbindungselements 14 mit einer ersten, oberen Kolbenanordnung verbunden. Hier ist das Verbindungselement 14 mit dem äusseren Ende einer Kolbenstange 23 der Kolbenanordnung verschraubt. Durch eine Bewegung der Kolbenanordnung in z-Richtung lässt sich der Stift 11 entsprechend mitbewegen.

Die erste Kolbenanordnung weist zudem einen Kolben 22 auf, der mit der Kolbenstange 23 verbunden, hier einstückig ausgebildet, ist. Die erste Kolbenanordnung ist im Inneren eines Gehäuses 21 eines Antriebszylinders (Hubzylinder) angeordnet. Das Gehäuse 21 ist vorzugsweise so ausgebildet, dass eine zylindrisch geformte Innenwand bereitgestellt ist und der Kolben 22 entlang einer hierdurch definierten Längsachse L (in und entgegen der z-Richtung) im Inneren des Gehäuses 21 bewegbar ist. Die Kolbenstange 23 erstreckt sich durch die obere Wand 21' (z.B. einstückig ausgebildeter oder aufgeschraubter Deckel) des Gehäuses 21 und ist ebenfalls und entsprechend des Kolbens 22 entlang der Längsachse L bewegbar.

Der erste Kolben 22 verfügt über ein Dichtelement 24, welches zwischen dem Kolben 22 und der Innenwand des Gehäuses 21 vorliegt und eine erste pneumatische Abdichtung für ein erstes, oberes Innenvolumens 25 bereitstellt. Das Dichtelement 24 kann z.B. als z-förmige Lippendichtung ausgeführt sein, wodurch ein definierter und konstanter Anpressdruck an die Innenwand bereitstellbar ist.

Die Grösse des ersten Innenvolumens 25 ist definiert durch einen Innendruchmesser bzw. eine Zylindergrundfläche des Gehäuses 21 und durch einen Abstand zwischen dem ersten Kolben 22 und einem zweiten, unteren Kolben 32.

Das erste Volumen 25 ist damit ein variables und in Abhängigkeit von einer Positionierung des ersten Kolbens 22 und/oder des zweiten Kolbens 32 entlang der Längsachse L bezüglich dessen räumlicher Ausdehnung veränderliches Volumen. In anderen Worte: wird der Abstand zwischen den beiden Kolben 22,32 verringert, so reduziert sich die Ausdehnung des Volumens 25 entsprechend; wird der Abstand vergrössert, so vergrössert sich auch das Volumen 25 entsprechend.

Der zweite Kolben 32 trennt das erste Innenvolumen 25 von einem zweiten Innenvolumen 35 ab. Der zweite Kolben 32 ist Teil einer zweiten Kolbenanordnung, die ebenfalls entlang der Längsachse L beweglich ist. Auch der zweite Kolben 32 verfügt über ein Dichtelement, das z.B. als z-förmige Lippendichtung um den Kolben 32 umlaufend angeordnet ist und wodurch ein definierter und konstanter Anpressdruck an die Innenwand bereitgestellt ist. Das zweite Innenvolumen 35 ist wie gezeigt durch den zweiten Kolben 32 und eine Unterseite 21' des Gehäuses 21 begrenzt.

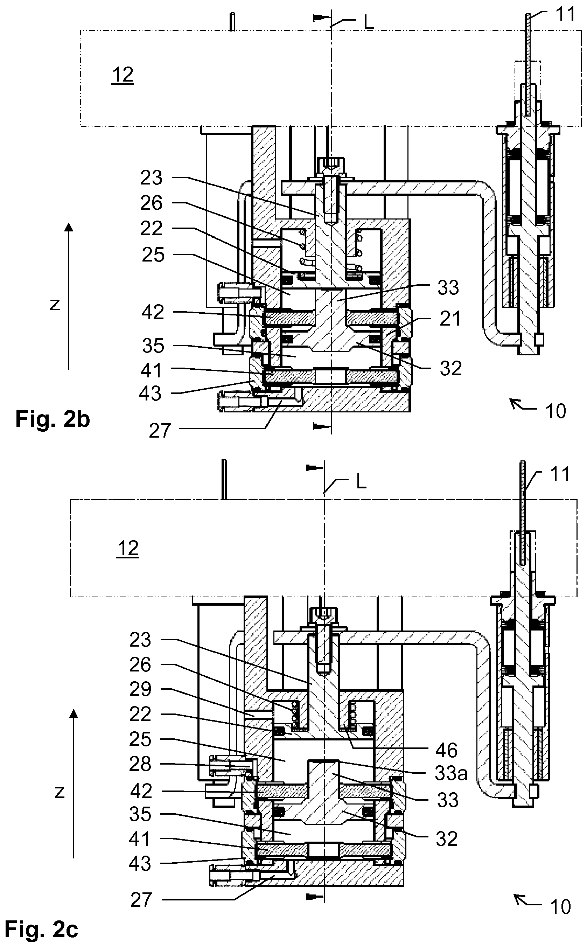

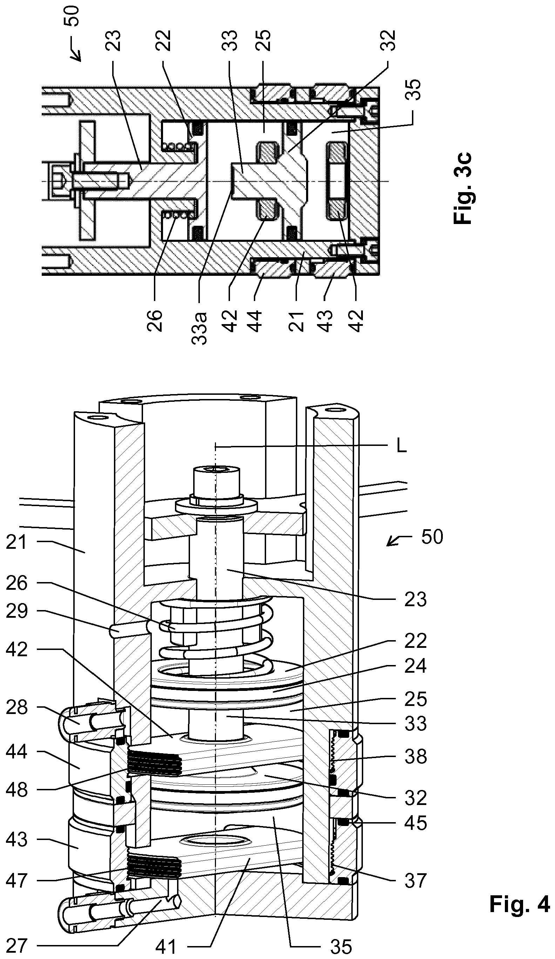

In der gezeigten Antriebsstellung, der eingefahrenen Bearbeitungsposition, steht die zweite Kolbenstange 33 mit dem ersten Kolben 22 in Kontakt. Wie aus den Figuren 2c und 3c ersichtlich, steht hierbei eine der zweiten Kolbenanordnung zugeordnete Kontaktfläche 33a mit dem ersten Kolben 22 in Kontakt. Die Kontaktfläche 33a bildet hierbei das Ende der zweiten Kolbenstange 33. Eine durch die Rückstellfeder 26 bewirkte Rückstellkraft bewirkt, dass der erste Kolben 22 und damit die gesamte erste Kolbenanordnung nach unten (entgegen der angezeigten z-Richtung) gedrückt wird und mit der ersten Kolbenanordnung durch den Kontakt zur zweiten Kolbenanordnung auch die zweite Kolbenanordnung entsprechend beaufschlagt wird. In dieser Bearbeitungsposition liegt keine pneumatische Druckbeaufschlagung in den beiden Innenvolumina 25 und 35 vor bzw. ist der Innendruck derart gering, dass die Rückstellkraft dennoch die gezeigte Positionierung der beiden Kolbenanordnungen vermag.

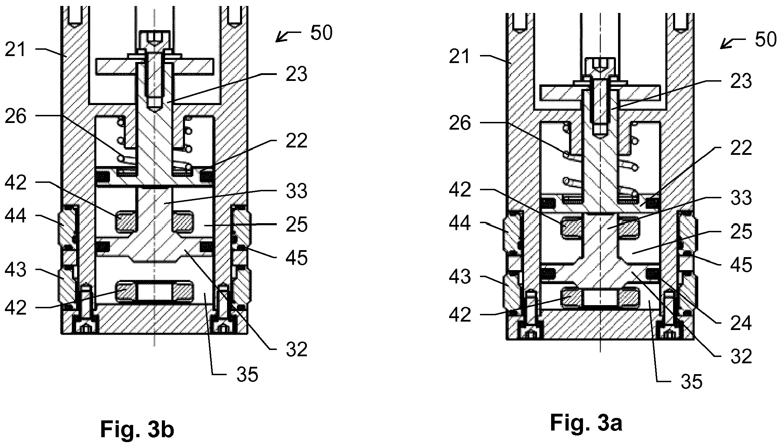

Der untere, zweite Kolben 32 schlägt in der Bearbeitungsposition an einem Anschlag 41 an und befindet sich dabei in einer tiefsten Nullpunktsstellung. Der Anschlag 41 ist als Querbalken ausgeführt und erstreckt sich quer über den Innendurchmesser des Gehäuses 21 und weiter in zwei gegenüberliegende Ausnehmungen, die in der Gehäusewand vorgesehen sind. Der in dem zweiten Innenvolumen vorliegende Querbalken 41 kann von Luft frei umströmt werden. Dies ist insbesondere auch aus den Figuren 3a-c ersichtlich.

Ein zweiter und analog ausgebildeter Anschlag 42 ist zwischen dem ersten und dem zweiten Kolben 22,32 vorgesehen. Dieser Anschlag 42 bildet zum einen einen Anschlagpunkt für eine Bewegung des zweiten Kolbens 32 aus der eingefahrenen Bearbeitungsposition in eine Übergangsposition. Der zweite Anschlag 42 definiert durch dessen Position entlang der Längsachse L die Übergangsposition.

In der gezeigten Ausführungsform ist sowohl der erste Anschlag 41 als auch der zweite Anschlag 42 in seiner Positionierung entlang der Längsachse L variierbar. Die Einstellbarkeit der Positionen der Anschläge 41,42 wird mittels jeweiliger Stellringe 43 und 44 bereitgestellt. Die Querbalken 41 und 42 weisen hierzu an deren Balkenenden, die in den Ausnehmungen vorliegen, Segmente eines Aussengwindes und die Ringe 43 und 44 vorzugsweise je ein umlaufendes Innengewinde auf. Die Ringe 43,44 sind derart an das Gehäuse 21 angeordnet und relativ zu den Ausnehmungen eingepasst, dass die Innengewinde der Ringe 43,44 mit den Aussengwindeteilen der Querbalken 41,42 zusammenwirken. Die Ringe 43,44 sind zudem mit dem Gehäuse 21 abgedichtet. Diese Dichtung ist hier durch die Ringe umlaufende O-Ringe (exemplarisch ist einer der 0-Ringe mit 45 bezeichnet), die in entsprechende Nuten eingepasst sind, bereitgestellt. Die O-Ringe liegen also zwischen den Ringen 43,44 und der Gehäusewand vor. Die 0-Ringe sind vorzugsweise gefettet um eine homogene Beweglichkeit (Drehbewegung) der Ringe 43,44 zu ermöglichen.

Die Dichtung kann allgemein aus Teflon (PTFE), FKM, FFKM oder einer Mischform daraus bestehen. Die Schmierung der Dichtung kann durch Fett bereitgestellt sein. Alternativ oder zusätzlich kann das Dichtelement (z.B. O-Ring) und/oder die Dichtfläche (z.B. Nut) eine spezifische Beschichtung für gleichzeitig ein leichtgängige Beweglichkeit der Ringe und eine erforderliche Abdichtwirkung. Die Dichtung kann z.B. mit dem Ring oder dem Gehäuse verbunden, z.B. aufvulkanisiert, sein.

Durch ein Drehen eines der Ringe 43,44 wird aufgrund des Ineinandergreifens der Innengewinde mit den Aussengwindeteilen der jeweilige Anschlag 41,42 in seiner Position in eine Richtung parallel zur Längsachse L verschoben. Die Position des Anschlags kann also im Rahmen der Ersteckung der Ausnehmung verändert und eingestellt werden, wobei die Dichtheit des Antriebszylinders gewährleistet bleibt und kein Eingriff in das Innere des Zylinders erfolgt.

Beispielsweise kann durch ein Drehen des unteren Rings 41 die eingefahrene Bearbeitungsposition (Nullpunktposition) eingestellt werden und dadurch ein Versenkungsgrad für die Tragstifte 11 in der Platte 12 eingestellt werden.

Die Figur 2b zeigt die Stifthubvorrichtung 10 in einem Übergangszustand, d.h. der zweite, untere Kolben 32 ist mittels Druckbeaufschlagung des zweiten Volumens 35 in die Übergangsposition gebracht. Hierbei hat der Kolben 32 einen weiteren Anschlagpunkt erreicht, der mittels des Querbalkens 42 definierbar und entsprechend einstellbar ist. Die zweite Kolbenstange 33 erstreckt sich durch einen entsprechend in dem Querbalken 42 vorgesehnen Durchgang (Ausnehmung).

Der Hub der Kolbenanordnungen in die Übergangsposition erfolgt durch eine Erhöhung des Innendrucks in dem zweiten Innenvolumen 35. Die Druckluft wird durch einen mit dem zweiten Innenvolumen 35 verbundenen Druckluftkanal 27 eingeleitet und bewirkt ein Anheben der zweiten Kolbenanordnung entgegen der Rückstellkraft der Feder 26.

Eine lineare Kolbenbewegung kann also durch den auf den zweiten Kolben 32 bewirkten Druck realisiert werden. Die erste Kolbenanordnung wird dabei mittels der zweiten Kolbenstange 33 entsprechend mit in z-Richtung bewegt.

Die Übergangsposition entspricht hier der weitest möglichen Bewegung des zweiten Kolbens 32 in z-Richtung. Die Übergangsposition ist wiederum durch den Anschlag 42 und den Ring 44 verstellbar.

Ein definiertes Bewegungsprofil für die Bewegung aus der Nullpunktposition in die Übergangsposition kann durch eine gezielte Druckvariation oder Druckbeaufschlagung eingestellt werden. Z.B. wird der Druck in dem zweiten Innenvolumen 35 langsam erhöht, damit ein Ausfahren der Tragstifte 11 und ein damit beabsichtigtes Anheben eines Substrats zunächst verhältnismässig langsam und dann mit bestimmter Geschwindigkeitszunahme erfolgen kann. Durch ein zunächst langsames Ausfahren der Stifte 11 können ein schonendes Abheben des Substrats und ein zerstörungsfreies Überwinden von allfällig auftretenden Adhäsionskräften (z.B. aufgrund eines Lufteinschlusses) erfolgen.

Für diese (passive) Hubbewegung der ersten Kolbenanordnung - geschoben durch die zweite Kolbenanordnung - kann das erste Innenvolumen 25 in einer belüfteten Einstellung vorliegen. Typischerweise jedoch bleibt die Ausdehnung des ersten Innenvolumens 25 in diesem Schritt ohnehin im Wesentlichen konstant und es ändert sich allein die Lage des Volumens 25 im Gehäuse 21.

Neben der schonenden Handhabung von derartigen Substraten ist bei der Bearbeitung von z.B. Siliziumwafern in einer Vakuumkammer der Durchsatz, also die Zeit, die für den Prozessschritt benötigt wird, ein wichtiger Faktor. Daher ist mit der vorliegenden Erfindung eine Lösung für einen Pin-Lifter vorgeschlagen, die zum einen eine entsprechend vorsichtige Handhabung des Substrats bereitstellt (siehe oben) und auf der anderen Seite eine vergleichsweise schnelle Positionierung des Substarts in einer Entnahme- bzw. Bestückungsposition ermöglicht. Diese beiden Faktoren werden durch das zweistufige Antriebskonzept erfüllt.

In der zweiten Stufe erfolgt ein Zustandsübergang aus der Übergangsposition in eine ausgefahrene Bestückungsposition wie in Figur 2c gezeigt. Die Stellung des zweiten Kolbens 32 bleibt hierbei unverändert. Durch einen weiteren Druckkanal 28 wird das erste Innenvolumen 25 mit einem Überdruck beaufschlagt. Der erste Kolben 22 wird dadurch weiter in z-Richtung gedrückt und hebt von der zweiten Kolbenstange 33 ab. Der erste Kolben 22 und die zweite Kolbenstange liegen dann kontaktlos vor. Die Bewegung des zweiten Kolbens 22 ist wiederum durch einen festen Anschlag 46 begrenzt. Hier liegt die Feder 26 insbesondere voll verpresst vor. Das erste Volumen 25 wird dabei vorzugsweise mit einem grösseren Druckanstieg beaufschlagt als das zweite Volumen 35, um einen schnelleres Heben der Stifte 11 zu realisieren. Dies kann bei gleichem Eingangsdruck an beiden Druckkanälen beispielsweise mittels einer entsprechend grösseren Durchflussblende erreicht werden.

Es versteht sich, dass der fixe Anschlag 46 eine reine Ausgestaltungsvariante verkörpert und dieser Anschlag 46 alternativ auch entsprechend einem der gezeigten verstellbaren Anschläge ausgestaltet sein kann. Umgekehrt betrifft die Erfindung auch einen Antriebszylinder, bei welchem nur einer der vorgesehenen Anschlagpunkte verstellbar ist.

Die Druckbeaufschlagung des ersten Volumens 25 erfolg entweder nach Erreichen der Übergangsposition oder zeitlich überlappend mit der Druckbeaufschlagung des zweiten Volumens 25, sodass eine kombinierte und entsprechend schnellere Bewegung der Tragstifte 11 erreicht werden kann. Die Steuerung dieser Druckbeaufschlagungen kann mittels einer z.B. elektronischen Steuerung oder mittels einer Umschaltweiche, die bei erreichen eines bestimmten Drucks einen beaufschlagten Druckkanal umschaltet, ausgeführt sein.

Im oberen Teil des Gehäuses 21 ist ein Ent- und Belüftungskanal vorgesehen, der das Entstehen eines Überdrucks oder Unterdrucks überhalb des ersten Kolbens 22 verhindert und damit eine ungehinderte Bewegung der ersten Kolbenanordnung ermöglicht.

Eine Rückstellung der beiden Kolbenelemente in die eingefahrenen Bearbeitungsposition, insbesondere wobei die Übergangsposition wiederum durchfahren wird, erfolgt durch ein kontrolliertes und ggf. gesteuertes Entlüften der beiden Innenvolumina 25,35.

Die Figuren 3a bis 3c zeigen eine Ausführungsform für einen Antriebszylinder 50 (Hubzylinder) gemäss der Erfindung, wobei dieser Zylinder ähnlich demjenigen aus den Figuren 2a-2c aufgebaut ist. Gleiche Bezugszeichen bezeichnen entsprechend gleichartige oder gleichwirkende Teile. Der Antriebszylinder 50 ist ebenfalls in drei unterschiedlichen Stellungen gezeigt - in der eingefahrenen Bearbeitungsposition (Fig. 3a), in der Übergangsposition (Fig. 3b) und in der ausgefahrene Bestückungsposition (Fig. 3c).

Die Beschreibung zu den einzelnen Stellungen des Pin-Lifters und eines damit ausführbaren Hubvorgangs der Figuren 2a-c sind auf den Antriebszylinder 50 entsprechend übertragbar.

Der Antriebszylinder 50 kann für eine Vielzahl unterschiedlicher Antriebskonzepte eingesetzt werden. Insbesondere kann der Zylinder 50 in einer oben gezeigten Stifthubvorrichtung vorgesehen sein.

Figur 4 zeigt eine weitere Ausführungsform eines Hubzylinders 50 (Antriebszylinder) gemäss der Erfindung in einer perspektivischen Darstellung. Die Funktionsweise entspricht im Wesentlichen der zuvor beschriebenen für die Figuren 2a-3c. Gleiche Bezugszeichen bezeichnen wiederum entsprechend gleichartige oder gleichwirkende Teile des Antriebs 50.

Eine erfindungsgemässe Einstelleinrichtung für die Position der beiden Anschläge 41 und 42 (Querbalken) bestehend aus den beiden Anschlagelementen 41 bzw. 42 und den damit zusammenwirkenden Stellringen 43 und 44 ist hierbei weiter verdeutlicht. In der gezeigten Ausführung weisen die Anschlagelemente 41 und 42 an deren beiden gegenüberliegenden (kurzen) Enden jeweils ein Segment eines Aussengewindes 47,48 mit definierter Steigung auf. Wie zu sehen, erstrecken sich die Enden der Anschlagelemente 41 und 42 in jeweilige Ausnehmungen des Gehäuses 21 und werden darin verdrehsicher gehalten.

Die beiden Stellelemente 43 und 44, hier als Stellringe 43 und 44 ausgebildet, weisen jeweilige umlaufende und mit den Aussengewinden 47 und 48 korrespondierende Innengewinde 37 und 38 auf. In anderen Worten, die Innengewinde 37 und 38 der Ringe greifen in die Aussengewinde 47 und 48 der Anschlagelemente und ermöglichen ein vertikales Verstellen der Anschlagelemente entlang der Längsachse L durch Drehen der Ringe.

Zumindest eine der beiden Einstelleinrichtungen ist derart ausgebildet, dass eine variierbare Positionierbarkeit des betreffenden Anschlagelements über mindestens ± 1 mm oder ± 2 mm gegeben ist. Weiterhin kann zumindest eine der beiden Einstelleinrichtungen selbsthemmend ausgelegt sein.

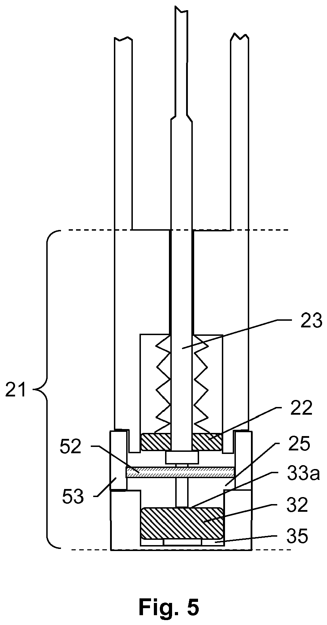

Figur 5 zeigt eine weitere Ausführungsform einer erfindungsgemässen Hubvorrichtung bzw. für deren Antrieb. Das Gehäuse 21 weist wiederum einen ersten Kolben 22 und einen zweiten Kolben 32 auf, die jeweils mittels Druckbeaufschlagung der Volumina 25 und 35 axial in dem Gehäuse beweglich sind.

Ein Anschlagelement 52 stellt einen Anschlagpunkt für den durch den zweiten Kolben 32 initiierten Bewegungsübergang in den durch den ersten Kolben 22 dominierten Bewegungsvorgang bereit. Ein Stellring 53 ermöglicht das axiale Verstellen der Position des Anschlagelements 52.

In dieser Ausführungsform erstreckt sich die erste Kolbenstange 23 durch den ersten Kolben 22 und berührt in der hier dargestellten Bearbeitungsposition eine Kontaktfläche 33a des zweiten Kolbens 32. Die zweite Kolbenanordnung kommt hier als ohne zweite Kolbenstange aus. Der erste Kolben 22 ist mit der ersten Kolbenstange 23 verschraubt.

Die erste Kolbenstange 23 erstreckt sich über das Gehäuse 21 hinaus und kann ausserhalb des Gehäuses 21 mit einem Tragstift eines Pin-Lifters gekoppelt sein. Insbesondere ist der Tragstift in der axialen Verlängerung der Kolbenstange 23 angeordnet.

Es versteht sich, dass die dargestellten Figuren nur mögliche Ausführungsbeispiele schematisch darstellen. Die verschiedenen Ansätze können erfindungsgemäss ebenso miteinander sowie mit Vorrichtungen zur Substratbearbeitung in Vakuumprozesskammern des Stands der Technik kombiniert werden.

## Patentansprüche

1. Stifthubvorrichtung (10), insbesondere Pin-Lifter, für die Bewegung und Positionierung eines zu bearbeitenden Substrats (1), insbesondere eines Wafers, mit
• einem pneumatischen Antriebszylinder (6,50) mit
□ einem ein erstes zylindrisches Innenvolumen (25) einschliessenden zylindrischen Gehäuse (21) und
□ einer entlang einer parallel oder koaxial zu einer Längsachse (L) erstreckten Bewegungsachse beweglich angeordneten ersten Kolbenanordnung mit einem ersten Kolben (22) und einer ersten Kolbenstange (23), wobei
• die Längsachse (L) durch das erste zylindrische Innenvolumen (25) definiert ist,
• der erste Kolben (22) das erste Innenvolumen (25) begrenzt,
• die erste Kolbenstange (23) aus dem zylindrischen Gehäuse (21) ragt und
• die erste Kolbenanordnung durch eine Druckbeaufschlagung des ersten Innenvolumens (25) in eine ausgefahrene Bestückungsposition verstellbar ist, und
• mindestens einem zumindest im Wesentlichen parallel oder koaxial in Richtung der Längsachse (L) beweglichen Tragstift (7,11), wobei
□ der Tragstift (7,11) mit einem ausserhalb des zylindrischen Gehäuses (21) vorliegenden äusseren Ende der ersten Kolbenstange (23) verbunden ist und
□ der Tragstift (7,11) durch eine Bewegung der ersten Kolbenanordnung linear bewegbar ist,
**dadurch gekennzeichnet, dass**
• der Antriebszylinder (6,50) eine zweite Kolbenanordnung mit einem zweiten Kolben (32) und einer Kontaktfläche (33a) aufweist, wobei
□ der zweite Kolben (32) ein von dem zylindrischen Gehäuse (21) eingeschlossenes zweites Innenvolumen (35) begrenzt, insbesondere wobei das erste und das zweite Innenvolumen durch den zweiten Kolben (32) voneinander getrennt sind,
□ die zweite Kolbenanordnung zumindest im Wesentlichen koaxial zur ersten Kolbenanordnung bewegbar angeordnet ist und
□ die Kontaktfläche (33a) der zweiten Kolbenanordnung in Richtung des ersten Kolbens (22) weist, und
• die erste Kolbenanordnung und die zweite Kolbenanordnung derart angeordnet sind, dass
□ die erste Kolbenanordnung und die Kontaktfläche (33a) in der Bestückungsposition berührungslos vorliegen und
□ die erste Kolbenanordnung und die Kontaktfläche (33a) in einer eingefahrenen Bearbeitungsposition in Berührung sind.

2. Stifthubvorrichtung (10) nach Anspruch 1,
**dadurch gekennzeichnet, dass**
• der Antriebszylinder (6,50) einen zweiten Druckluftkanal (27) aufweist, der derart angeordnet ist, dass die zweite und insbesondere die erste Kolbenanordnung durch eine Druckbeaufschlagung des zweiten Innenvolumens (35) durch den zweiten Druckluftkanal (27) aus der eingefahrenen Bearbeitungsposition in eine Übergangsposition verstellbar ist, und
• der Antriebszylinder (6,50) einen ersten Druckluftkanal (28) aufweist, der derart angeordnet ist, dass die erste Kolbenanordnung durch eine Druckbeaufschlagung des ersten Innenvolumens (25) durch den ersten Druckluftkanal (28) aus der Übergangsposition in die ausgefahrene Bestückungsposition verstellbar ist.

3. Stifthubvorrichtung (10) nach Anspruch 2,
**dadurch gekennzeichnet, dass**
die Stifthubvorrichtung (10) eine Steuerungseinheit zur Ansteuerung jeweiliger Druckluftregelelement für den ersten und den zweiten Druckluftkanal aufweist und die Steuerungseinheit eine derart konfigurierte Hebefunktion zur Bewegung der ersten Kolbenanordnung in eine ausgefahrene Bestückungsposition aufweist, dass bei deren Ausführung
• das Druckluftregelelement für den zweiten Druckluftkanal (27) die Druckbeaufschlagung des zweiten Innenvolumens (35) bereitstellt und
• nachfolgend das Druckluftregelelement für den ersten Druckluftkanal (28) die Druckbeaufschlagung des ersten Innenvolumens (25) mit einem bestimmten zeitlichen Versatz relativ zur Druckbeaufschlagung des zweiten Innenvolumens (35) bereitstellt, wobei der zeitliche Versatz
• von einem Erreichen der Übergangsposition mit dem zweiten Kolben (32) abhängt oder
• zeitlich gesteuert durch die Hebefunktion vorgegeben ist.

4. Stifthubvorrichtung (10) nach einem der Ansprüche 1 bis 3,
**dadurch gekennzeichnet, dass**
• der Antriebszylinder (6,50) zumindest einen Anschlagpunkt für eine Bewegung der ersten oder der zweiten Kolbenanordnung, insbesondere des ersten oder zweiten Kolbens, definiert, wobei der zumindest eine Anschlagpunkt die ausgefahrene Bestückungsposition, die eingefahrenen Bearbeitungsposition und/oder die Übergangsposition definiert, und
• die Position des zumindest einen Anschlagpunkts in einem definierten Anschlagbereich entlang einer zumindest im Wesentlichen parallel zur Längsachse (L) erstreckten Verstellachse variierbar ist, insbesondere wobei eine Erstreckung des Anschlagbereichs mindestens 0.5 mm oder 1 mm in Richtung der Längsachse (L) beträgt.

5. Stifthubvorrichtung (10) nach einem der Ansprüche 1 bis 4,
**dadurch gekennzeichnet, dass**
der Antriebszylinder (6,50) zumindest eine Rückstellfunktionalität aufweist, mittels derer eine Rückstellkraft bereitstellbar ist, welche so auf die erste und/oder die zweite Kolbenanordnung wirkt, dass diese in die eingefahrene Bearbeitungsposition gedrückt wird,
insbesondere wobei die Rückstellfunktionalität ausgebildet ist als
• Rückstellelement (26), insbesondere Rückstellfeder, die derart angeordnet ist, dass die Rückstellkraft auf den ersten Kolben (22) wirkt, oder
• steuerbarer, insbesondere pneumatischer, Rückstellmechanismus, wobei die Rückstellkraft auf den ersten Kolben (22) durch Druckbeaufschlagung, insbesondere hinsichtlich deren Betrags, einstellbar ist.

6. Stifthubvorrichtung (10) nach einem der Ansprüche 1 bis 5,
**dadurch gekennzeichnet, dass**
• die zweite Kolbenanordnung eine zweite Kolbenstange (33) aufweist,
• eine Endfläche der zweiten Kolbenstange (33) in Richtung der ersten Kolbenanordnung weist und
• die Endfläche die Kontaktfläche (33a) repräsentiert, wobei
• der erste Kolben (22) und die zweite Kolbenstange (33) in der Bestückungsposition berührungslos vorliegen und
• der erste Kolben (22) und die zweite Kolbenstange (33) in der eingefahrenen Bearbeitungsposition in Berührung sind,
und/oder
• die erste Kolbenstange (23) derart ausgeformt ist, dass ein freies inneres Ende der ersten Kolbenstange (33), das dem äusseren Ende der ersten Kolbenstange (23) gegenüberliegt, in Richtung der Kontaktfläche (33a) weist, wobei
□ die erste Kolbenstange (23) und die Kontaktfläche (33a) in der Bestückungsposition berührungslos vorliegen und
□ die erste Kolbenstange (23) und die Kontaktfläche (33a) in einer eingefahrenen Bearbeitungsposition in Berührung sind,
insbesondere wobei die erste Kolbenstange (23) sich durch den ersten Kolben 22 erstreckend ausgebildet und in fixer Position, insbesondere mittels Verschraubung, relativ zum ersten Kolben 22 angeordnet ist.

7. Stifthubvorrichtung (10) nach einem der Ansprüche 1 bis 6,
**dadurch gekennzeichnet, dass**
der Antriebszylinder (6,50) gemäss einem der Ansprüche 8 bis 15 ausgebildet ist.

8. Pneumatischer Antriebszylinder (6,50), insbesondere Hubzylinder, insbesondere für eine
Stifthubvorrichtung (10) oder einen Pin-Lifter, mit
• einem ein erstes zylindrisches Innenvolumen (25) einschliessenden zylindrischen Gehäuse (21) und
• einer entlang einer parallel oder koaxial zu einer Längsachse (L) erstreckten Bewegungsachse beweglich angeordneten ersten Kolbenanordnung mit einem ersten Kolben (22) und einer ersten Kolbenstange (23), wobei
□ die Längsachse (L) durch das erste zylindrische Innenvolumen (25) definiert ist,
□ der erste Kolben (22) das erste Innenvolumen (25) begrenzt,
□ die erste Kolbenstange (23) aus dem zylindrischen Gehäuse (21) ragt und
□ die erste Kolbenanordnung durch eine Druckbeaufschlagung des ersten Innenvolumens (25) in eine ausgefahrene Bestückungsposition verstellbar ist,
• einem an einem ausserhalb des zylindrischen Gehäuses (21) vorliegenden äusseren Ende der ersten Kolbenstange (23) vorgesehenen Koppelelement zur Verbindung der ersten Kolbenstange (23) mit einer mittels des Antriebszylinders (6,50) zu bewegenden Komponente (11,13), insbesondere Tragstift einer Stifthubvorrichtung (10), und
• einer zweiten Kolbenanordnung mit einem zweiten Kolben (32) und einer Kontaktfläche (33a), wobei
□ der zweite Kolben (32) ein von dem zylindrischen Gehäuse (21) eingeschlossenes zweites Innenvolumen (35) begrenzt, insbesondere wobei das erste und das zweite Innenvolumen durch den zweiten Kolben (32) voneinander getrennt sind,
□ die zweite Kolbenanordnung zumindest im Wesentlichen koaxial zur ersten Kolbenanordnung bewegbar angeordnet ist,
□ die Kontaktfläche (33a) in Richtung des ersten Kolbens (22) weist, und
□ die zweite und insbesondere die erste Kolbenanordnung durch eine Druckbeaufschlagung des zweiten Innenvolumens (35) aus einer eingefahrenen Bearbeitungsposition in eine Übergangsposition verstellbar ist,
wobei die erste Kolbenanordnung und die zweite Kolbenanordnung derart angeordnet sind, dass
• die erste Kolbenanordnung und die Kontaktfläche (33a) in der ausgefahrenen Bestückungsposition berührungslos vorliegen und
• die erste Kolbenanordnung und die Kontaktfläche (33a) in einer eingefahrenen Bearbeitungsposition in Berührung sind,
**dadurch gekennzeichnet, dass**
• der Antriebszylinder (6,50) zumindest einen Anschlagpunkt für eine Begrenzung einer Bewegungsstrecke der ersten und/oder der zweiten Kolbenanordnung, insbesondere des ersten oder zweiten Kolbens, aufweist, wobei der zumindest eine Anschlagpunkt die ausgefahrene Bestückungsposition, die eingefahrenen Bearbeitungsposition und/oder die Übergangsposition definiert, und
• die Position des zumindest einen Anschlagpunkts innerhalb eines definierten Anschlagbereichs entlang einer zumindest im Wesentlichen parallel zur Längsachse (L) erstreckten Verstellachse variierbar ist, insbesondere wobei eine Erstreckung des Anschlagbereichs mindestens 0.5 mm oder 1 mm entlang der Verstellachse beträgt.

9. Pneumatischer Antriebszylinder (6,50) nach Anspruch 8,
**dadurch gekennzeichnet, dass**
• die zweite Kolbenanordnung eine zweite Kolbenstange (33) aufweist,
• eine Endfläche der zweiten Kolbenstange (33) in Richtung der ersten Kolbenanordnung weist, und
• die Endfläche die Kontaktfläche (33a) repräsentiert, wobei
• der erste Kolben (22) und die zweite Kolbenstange (33) in der Bestückungsposition berührungslos vorliegen und
• der erste Kolben (22) und die zweite Kolbenstange (33) in der eingefahrenen Bearbeitungsposition in Berührung sind.

10. Pneumatischer Antriebszylinder (6,50) nach Anspruch 8 oder 9,
**dadurch gekennzeichnet, dass**
die erste Kolbenstange (23) derart ausgeformt ist, dass ein freies inneres Ende der ersten Kolbenstange (33), das dem äusseren Ende der ersten Kolbenstange (23) gegenüberliegt, in Richtung der Kontaktfläche (33a) weist, wobei
• die erste Kolbenstange (23) und die Kontaktfläche (33a) in der Bestückungsposition berührungslos vorliegen und
• die erste Kolbenstange (23) und die Kontaktfläche (33a) in einer eingefahrenen Bearbeitungsposition in Berührung sind, insbesondere wobei die erste Kolbenstange (23) sich durch den ersten Kolben 22 erstreckend ausgebildet und in fixer Position, insbesondere mittels Verschraubung, relativ zum ersten Kolben 22 angeordnet ist.

11. Pneumatischer Antriebszylinder (6,50) nach einem der Ansprüche 8 bis 10,
**dadurch gekennzeichnet, dass**
• das Gehäuse (21) mindestens zwei insbesondere radial gegenüberliegende Ausnehmungen aufweist, wobei die Ausnehmungen die Gehäusewand durchdringen, und
• eine Erstreckung der Ausnehmungen entlang der Verstellachse den Anschlagbereich definiert.

12. Pneumatischer Antriebszylinder (6,50) nach Anspruch 11, **dadurch gekennzeichnet, dass**
der Antriebszylinder (6,50)
• zumindest ein in den Ausnehmungen angeordnetes Anschlagelement (41,42,52), insbesondere einen Querbalken, mit einer definierten Höhe in Richtung der Verstellachse aufweist, wobei die Höhe kleiner ist als die Erstreckung der Ausnehmungen, und
• zumindest einen mit dem Anschlagelement (41,42,52) zusammenwirkenden Verstellmechanismus (43,44,53) aufweist.

13. Pneumatischer Antriebszylinder (6,50) nach Anspruch 12, **dadurch gekennzeichnet, dass**
• der Verstellmechanismus (43,44,53) als Ring mit einem Innengewinde (37,38) ausgebildet und an der Gehäuseaussenseite angeordnet ist,
• das Anschlagelement (41,42,52) im Bereich der Ausnehmungen ein Segment eines mit dem Innengewinde (37,38) korrespondierenden Aussengewindes (47,48) aufweist und das Anschlagelement (41,42,52) derart ausgeformt ist, insbesondere hinsichtlich dessen Dimensionierung bezüglich eines Innen- und/oder Aussendurchmessers des Innenvolumens bzw. des Gehäuses (21), dass das Innengewinde (37,38) mit dem Aussengewinde (47,48) zusammenwirkt, und
• die Position des Anschlagelements (41,42) innerhalb des definierten Anschlagbereichs entlang der Verstellachse mittels Drehen des Rings (43,44,53) variierbar und einstellbar ist, wobei der zumindest eine Anschlagpunkt verstellbar ist.

14. Pneumatischer Antriebszylinder (6,50) nach einem der Ansprüche 8 bis 13,
**dadurch gekennzeichnet, dass**
der Antriebszylinder (6,50) zumindest eine Rückstellfunktionalität aufweist, mittels derer eine Rückstellkraft bereitstellbar ist, welche so auf die erste und/oder die zweite Kolbenanordnung wirkt, dass diese in die eingefahrene Bearbeitungsposition gedrückt wird,
insbesondere wobei die Rückstellfunktionalität ausgebildet ist als
• Rückstellelement (26), insbesondere Rückstellfeder, die derart angeordnet ist, dass die Rückstellkraft auf den ersten Kolben wirkt, oder
• steuerbarer, insbesondere pneumatischer, Rückstellmechanismus, wobei die Rückstellkraft auf den ersten Kolben durch Druckbeaufschlagung, insbesondere hinsichtlich deren Betrags, einstellbar ist.

15. Pneumatischer Antriebszylinder (6,50) nach einem der Ansprüche 8 bis 14,
**dadurch gekennzeichnet, dass**
• der Antriebszylinder (6,50) einen ersten Druckluftkanal (28) aufweist, der derart angeordnet ist, dass die erste Kolbenanordnung durch eine Druckbeaufschlagung des ersten Innenvolumens (25) durch den ersten Druckluftkanal (28) aus der Übergangsposition in die ausgefahrene Bestückungsposition verstellbar ist, und
• der Antriebszylinder (6,50) einen zweiten Druckluftkanal (27) aufweist, der derart angeordnet ist, dass die zweite und insbesondere die erste Kolbenanordnung durch eine Druckbeaufschlagung des zweiten Innenvolumens (35) durch den zweiten Druckluftkanal (27) aus der eingefahrenen Bearbeitungsposition in eine Übergangsposition verstellbar ist.
